# EUROPEAN PATENT APPLICATION

(11) **EP 4 682 603 A1**
(43) Date of publication of application: **21.01.2026**
(21) Application number: 24778110.7
(22) Date of filing: 28.03.2024
(51) Int. Cl.: G02B 6/12, H04B 10/25, G02B 6/122, G02B 6/24, G02B 6/42, G02B 6/38, G02B 6/44

(54) **OPTICAL CHIP, PHOTOELECTRIC CONVERSION APPARATUS, CO-PACKAGED OPTICS CHIP AND OPTICAL COMMUNICATION DEVICE**

(30) Priority: 31.03.2023 CN 202310355290
(71) Applicant: Huawei Technologies Co., Ltd., Shenzhen, Guangdong 518129 (CN)
(72) Inventor: ZHANG, Wenqi, Shenzhen, Guangdong 518129 (CN); XIAO, Pengcheng, Shenzhen, Guangdong 518129 (CN)
(74) Representative: Goddar, Heinz J.
(86) International application number: PCT/CN2024/084290
(87) International publication number: WO 2024/199324

(57) **Abstract**

Embodiments of this application disclose an optical chip, a photoelectric conversion apparatus, a co-packaged optics chip, and an optical communication device, which are configured to ensure that a first coupling end of an optical fiber and a second coupling end of an optical waveguide are always in a coupled state in a high-temperature environment, and further ensures coupling efficiency between the optical fiber and the optical waveguide. The optical chip shown in embodiments of this application includes an optical fiber connector, a photonic integrated circuit PIC, a protective housing, and an injection molding layer. The protective housing is located between the injection molding layer and the PIC, and coupling space is formed between the protective housing and the PIC. The optical fiber connector includes an optical fiber. The optical fiber connector has a first connection end that faces the PIC and a second connection end that is away from the PIC. A first coupling end of the optical fiber passes through the first connection end. The first coupling end and a second coupling end of an optical waveguide of the PIC both extend into the coupling space, and the first coupling end located in the coupling space is coupled to the second coupling end. The second connection end is configured to detachably connect to another optical fiber connector.

## Description

This application claims priorities to Chinese Patent Application No. CN202310355290.0, filed with the China National Intellectual Property Administration on March 31, 2023 and entitled "OPTICAL CHIP, PHOTOELECTRIC CONVERSION APPARATUS, CO-PACKAGED OPTICS CHIP, AND OPTICAL COMMUNICATION DEVICE", which is incorporated herein by reference in its entirety.

### TECHNICAL FIELD

This application relates to the field of optical communication technologies, and in particular, to an optical chip, a photoelectric conversion apparatus, a co-packaged optics chip, and an optical communication device.

### BACKGROUND

Co-packaged optics (co-packaged optics, CPO) means that a logic processing chip and a photoelectric conversion apparatus are packaged together. The photoelectric conversion apparatus is connected to a fiber array unit (fiber array unit, FAU), and the photoelectric conversion apparatus receives and sends an optical signal through the FAU. The co-packaged optics manner shortens a distance between the logic processing chip and the photoelectric conversion apparatus, which allows an electrical signal to be transmitted faster between the logic processing chip and the photoelectric conversion apparatus.

The photoelectric conversion apparatus and the logic processing chip are separately soldered to a switch substrate (switch substrate) at a high temperature in a reflow soldering oven. However, the FAU connected to the photoelectric conversion apparatus cannot withstand the high temperature in the reflow soldering oven, which causes the FAU to be faulty. Therefore, the photoelectric conversion apparatus and the switch substrate may be interconnected via a socket (socket) through mechanical crimping. The photoelectric conversion apparatus and the switch substrate are interconnected via the socket. In this way, the photoelectric conversion apparatus and the switch substrate can be interconnected when the FAU does not need to withstand the high temperature in the reflow soldering oven.

However, compared with a manner in which the photoelectric conversion apparatus is soldered to the switch substrate for interconnection, interconnection between the photoelectric conversion apparatus and the switch substrate via the socket increases a distance between the photoelectric conversion apparatus and the switch substrate, and increases power consumption of transmitting the electrical signal between the photoelectric conversion apparatus and the logic processing chip.

### SUMMARY

Embodiments of this application provide an optical chip, a photoelectric conversion apparatus, a co-packaged optics chip, and an optical communication device, which can ensure that a first coupling end of an optical fiber and a second coupling end of an optical waveguide are always in a coupled state in a high-temperature environment, and further ensures coupling efficiency between the optical fiber and the optical waveguide.

A first aspect of this application provides an optical chip, including an optical fiber connector, a photonic integrated circuit PIC, a protective housing, and an injection molding layer. The protective housing is located between the injection molding layer and the PIC, and coupling space is formed between the protective housing and the PIC. The optical fiber connector includes an optical fiber. The optical fiber connector has a first connection end that faces the PIC and a second connection end that is away from the PIC. A first coupling end of the optical fiber passes through the first connection end. The first coupling end and a second coupling end of an optical waveguide of the PIC both extend into the coupling space, and the first coupling end located in the coupling space is coupled to the second coupling end. The second connection end is configured to detachably connect to another optical fiber connector.

As shown in this aspect, the coupling space formed between the protective housing and the PIC can enable the first coupling end and the second coupling end to be always in a coupled state. In addition, the protective housing can effectively prevent the coupled state between the first coupling end of the optical fiber and the second coupling end of the optical waveguide from being damaged at a high temperature. This effectively ensures coupling efficiency between the first coupling end of the optical fiber and the second coupling end of the optical waveguide.

Based on the first aspect, in an optional implementation, a groove is concavely disposed on a surface that is of the PIC and that faces the protective housing. The groove is configured to fasten the first coupling end. An axial center of the first coupling end located in the groove is aligned with an axial center of the second coupling end.

Based on the first aspect, in an optional implementation, the groove has a first side wall and a second side wall that are at opposite positions. The first coupling end separately abuts against the first side wall and the second side wall.

In this implementation, based on limitation effect of the groove on a position of the first coupling end, it can be ensured that the axial center of the first coupling end in the groove is always aligned with the axial center of the second coupling end of the optical waveguide, which ensures coupling efficiency between the optical waveguide and the optical fiber.

Based on the first aspect, in an optional implementation, an included angle between the first side wall and the second side wall is an acute angle.

In this implementation, when the included angle between the first side wall and the second side wall is the acute angle, a quantity of grooves per unit length can be effectively increased, which effectively increases a quantity of optical fibers included in the optical chip, and improves density of the optical fibers.

Based on the first aspect, in an optional implementation, there is a groove opening at a position that is of the groove and that faces the protective housing, and the protective housing covers the groove opening in a direction perpendicular to the surface of the PIC. The first coupling end further abuts against the protective housing through the groove opening.

In this implementation, the first side wall of the groove, the second side wall of the groove, and the protective housing at the groove opening can all limit the position of the first coupling end of the optical fiber, and can ensure that the axial center of the first coupling end in the groove is always aligned with the axial center of the second coupling end of the optical waveguide.

Based on the first aspect, in an optional implementation, there is a gap between the PIC and the optical fiber connector. The optical fiber includes a connection section connected between the first coupling end and the optical fiber connector. The connection section passes through the gap, to enable the first coupling end to extend into the coupling space. A first orthographic projection and a second orthographic projection are obtained when a projection ray is separately incident to the connection section and the protective housing in a direction perpendicular to the surface of the PIC, and the first orthographic projection is located within coverage of the second orthographic projection.

As shown in this implementation, because the first orthographic projection is located within the coverage of the second orthographic projection, the protective housing can protect the connection section of the optical fiber, which reduces an acting force applied by the injection molding layer on the connection section of the optical fiber. This effectively avoids breakage between a connection end of the optical fiber and the first coupling end, and avoids a case in which the connection section of the optical fiber causes position shift to the first coupling end under the acting force applied by the injection molding layer. The protective housing can ensure that the axial center of the first coupling end is always in a state of being aligned with the axial center of the second coupling end, which ensures coupling efficiency between the first coupling end and the second coupling end.

Based on the first aspect, in an optional implementation, in the direction perpendicular to the surface of the PIC, there is a first distance between the first coupling end and the protective housing, and there is a second distance between the connection section and the protective housing. The second distance is not greater than the first distance.

In this implementation, the protective housing reduces a thickness of an injection molding layer deposited on the connection section of the optical fiber, thereby reducing an acting force applied by the injection molding layer on the connection section.

A second aspect of this application provides a photoelectric conversion apparatus, including at least one electronic integrated circuit EIC and the optical chip according to any implementation of the first aspect. Each of the at least one EIC is electrically connected to the optical chip.

For descriptions of beneficial effects of this aspect, refer to the descriptions shown in the first aspect. Details are not described again.

Based on the second aspect, in an optional implementation, each EIC is flip-chip soldered to a transfer substrate, the optical chip is flip-chip soldered to a side surface that is of the EIC and that is away from the transfer substrate, and the EIC is electrically connected to the optical chip through the transfer substrate.

Based on the second aspect, in an optional implementation, the optical chip is flip-chip soldered to a transfer substrate, the EIC is flip-chip soldered to a side surface that is of the optical chip and that is away from the transfer substrate, and the EIC is electrically connected to the optical chip through the transfer substrate.

Based on the second aspect, in an optional implementation, the optical chip and each EIC are both flip-chip soldered to a transfer substrate, and the EIC is electrically connected to the optical chip through the transfer substrate.

A third aspect of this application provides a co-packaged optics chip, including a switch substrate, a logic processing chip, and the photoelectric conversion apparatus according to any implementation of the second aspect. The logic processing chip and the photoelectric conversion apparatus are both flip-chip soldered to the switch substrate.

For descriptions of beneficial effects of this aspect, refer to the descriptions shown in the first aspect. Details are not described again.

A fourth aspect of this application provides an optical communication device, including an outer housing, a circuit board, a laser, and the co-packaged optics chip according to the third aspect. The inside of the outer housing is configured to fasten the circuit board. The laser and the co-packaged optics chip are both packaged on a surface of the circuit board. The laser is configured to send a first optical signal to the co-packaged optics chip. The co-packaged optics chip is configured to modulate the first optical signal to obtain a modulated first optical signal, and the co-packaged optics chip is configured to emit the modulated first optical signal. Alternatively, the co-packaged optics chip is configured to receive a second optical signal, and the co-packaged optics chip is further configured to convert the second optical signal into an electrical signal through optical-to-electrical conversion.

A fifth aspect of this application provides an optical network. The optical network includes a plurality of optical communication devices. For descriptions of a structure and beneficial effects of each optical communication device, refer to the descriptions shown in the fourth aspect. Details are not described again.

### BRIEF DESCRIPTION OF DRAWINGS

FIG. 1 is an example top view of a structure of a CPO chip according to this application;
FIG. 2 is an example sectional view of a structure of a CPO chip according to this application;
FIG. 3 is an example diagram of a structure of a first embodiment of a photoelectric conversion apparatus according to this application;
FIG. 4 is an example diagram of a structure of a first embodiment of an optical chip according to this application;
FIG. 5 is an example top view of a structure of an embodiment of a part of optical chips according to this application;
FIG. 6 is an example diagram of connecting an optical fiber connector of an optical chip according to this application to another optical fiber connector;
FIG. 7 is an example projection diagram of an embodiment of a part of optical chips according to this application;
FIG. 8 is an example diagram of an orthographic projection shown in FIG. 7;
FIG. 9 is an example diagram of a structure of an optical chip in a first plane according to this application;
FIG. 10 is an example diagram of a structure of an optical chip in a second plane according to this application;
FIG. 11 is an example diagram of a structure of an embodiment of an optical fiber connector according to this application;
FIG. 12 is an example diagram of another structure of an optical chip in a first plane according to this application;
FIG. 13 is an example projection diagram of another embodiment of a part of optical signals according to this application;
FIG. 14 is an example diagram of an orthographic projection shown in FIG. 13;
FIG. 15 is an example diagram of another structure of an optical chip in a first plane according to this application;
FIG. 16 is an example diagram of a structure of a second embodiment of a photoelectric conversion apparatus according to this application;
FIG. 17 is an example diagram of a structure of a third embodiment of a photoelectric conversion apparatus according to this application;
FIG. 18 is an example diagram of a structure of a fourth embodiment of a photoelectric conversion apparatus according to this application; and
FIG. 19 is an example diagram of a structure of an embodiment of an optical communication device according to this application.

### DESCRIPTION OF EMBODIMENTS

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

This application provides an optical communication device, and the optical communication device is used in an optical network. The optical network has advantages such as a high switching speed, a low optical power loss, a low latency, and low costs. The optical network shown in this example may be applied to a data center network (data center network, DCN), a metropolitan area network, a passive optical network (passive optical network, PON), an optical transport network (optical transport network, OTN), or the like. This is not specifically limited. The optical network includes one or more optical communication devices. The optical communication device may be an optical line terminal (optical line terminal, OLT), an optical network unit (optical network unit, ONU), an OTN device, or the like. This is not specifically limited. A specific device type of the optical communication device is not limited in this embodiment. For example, the optical communication device may also be referred to as a router, a switch, a server, or an OTN transport device.

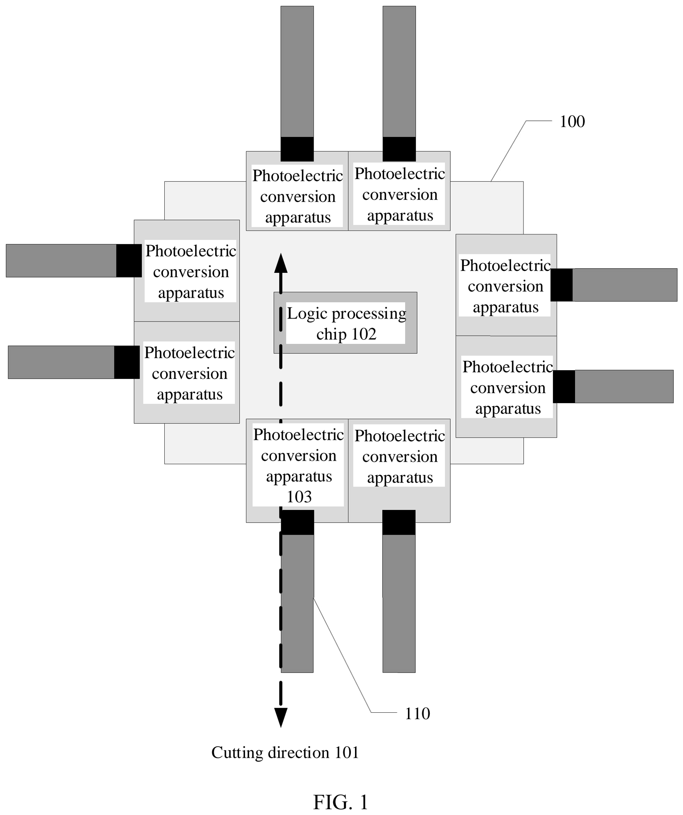

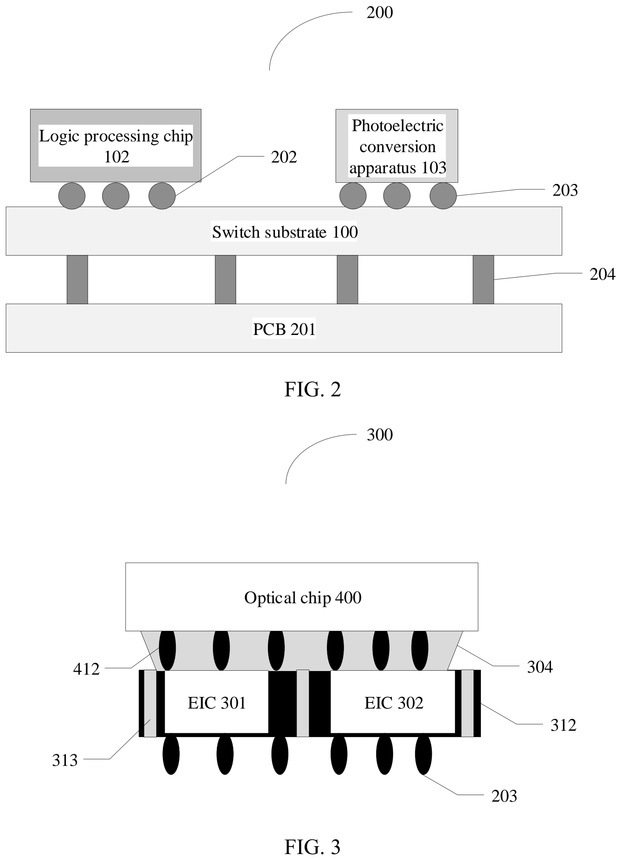

The optical communication device includes a CPO chip. FIG. 1 is an example top view of a structure of the CPO chip according to this application. FIG. 2 is an example sectional view of the structure of the CPO chip according to this application. The CPO chip includes a switch substrate 100, a logic processing chip 102, and a plurality of photoelectric conversion apparatuses. The sectional view 200 shown in FIG. 2 is that the CPO chip is cut in a cutting direction 101 shown in FIG. 1, so that the sectional view 200 shows a position relationship between the logic processing chip 102, a photoelectric conversion apparatus 103, the switch substrate 100, and a printed circuit board (printed circuit board, PCB) 201. A quantity of the photoelectric conversion apparatuses included in the CPO chip is not limited in this embodiment. The logic processing chip 102 and each photoelectric conversion apparatus are packaged on the same switch substrate 100, to implement co-packaged optics between the logic processing chip 102 and each photoelectric conversion apparatus. This shortens a distance between the logic processing chip 102 and each photoelectric conversion apparatus, and reduces power consumption of transmitting an electrical signal between the logic processing chip 102 and each photoelectric conversion apparatus, thereby reducing a bit error ratio (bit error ratio, BER) of the optical communication device.

The photoelectric conversion apparatus 103 is used as an example. The photoelectric conversion apparatus 103 is flip-chip soldered to the switch substrate 100 by using a ball grid array (ball grid array, BGA) packaging technology. Flip-chip soldering means that the photoelectric conversion apparatus 103 is disposed on the switch substrate 100, and a front surface of the photoelectric conversion apparatus 103 faces the switch substrate 100. The front surface of the photoelectric conversion apparatus 103 is a surface that is of the photoelectric conversion apparatus and on which an electrical connecting member is disposed. The electrical connecting member may be a solder ball. To electrically connect the photoelectric conversion apparatus 103 to the switch substrate 100, solder balls of the photoelectric conversion apparatus 103 are soldered to the switch substrate 100. For descriptions of flip-chip soldering the logic processing chip 102 to the switch substrate 100 by using the BGA, refer to the descriptions of flip-chip soldering the photoelectric conversion apparatus 103 to the switch substrate 100 by using the BGA. Details are not described herein again. The logic processing chip 102 is electrically connected to the photoelectric conversion apparatus 103 through the switch substrate 100. When the photoelectric conversion apparatus 103 and the logic processing chip 102 are both flip-chip soldered to the switch substrate 100, a distance between the photoelectric conversion apparatus and the switch substrate 100 can be effectively shortened, and a distance between the logic processing chip 102 and the switch substrate 100 can be effectively shortened. This further shortens the distance between the photoelectric conversion apparatus 103 and the logic processing chip 102, and effectively reduces power consumption of transmitting the electrical signal between the photoelectric conversion apparatus 103 and the logic processing chip 102.

For example, the logic processing chip 102 may be an application-specific integrated circuit (application-specific integrated circuit, ASIC). This is not specifically limited. For example, the logic processing chip 102 may also be a field-programmable gate array (field-programmable gate array, FPGA), a system on chip (system on chip, SoC), a central processing unit (central processing unit, CPU), a network processor (network processor, NP), a digital signal processor (digital signal processor, DSP), a microcontroller unit (microcontroller unit, MCU), a programmable controller (programmable logic device, PLD), or another integrated chip, or any combination of the chips.

An optical component such as a driver (Driver, DRV), a trans-impedance amplifier (trans-impedance amplifier, TIA), or a laser may be further packaged on the PCB 201 that is used to package the switch substrate 100 and that is shown in this embodiment. An electrical signal is transmitted between the TIA and the photoelectric conversion apparatus based on the PCB 201. The TIA is configured to amplify a power of the electrical signal transmitted between the photoelectric conversion apparatus and the logic processing chip 102. The driver drives, based on the PCB 201, the laser to emit light. For descriptions of the optical component packaged on the PCB 201 in this embodiment, refer to the foregoing descriptions of packaging the logic processing chip 102 on the switch substrate 100. Details are not described again. A type of the optical component packaged on the PCB 201 is not limited in this embodiment. Optionally, at least one of the foregoing plurality of types of optical components may be directly packaged on the switch substrate 100. The PCB 201 is electrically connected to the switch substrate 100, to electrically connect, based on the switch substrate 100 and the CPB 201, the optical component packaged on the switch substrate 100 to the optical component packaged on the PCB 201. The switch substrate 100 shown in this embodiment may include one or more layers of plates, and a conductive trace is arranged on one or dual surfaces of each plate. A type of the plate is not limited in this embodiment. For example, the plate may be a paper base, a glass fiber cloth base, a composite base, a ceramic base, or a metal core base. Any two optical components packaged on the switch substrate 100 are electrically connected based on the conductive trace of the switch substrate 100. For descriptions of the PCB 201, refer to the descriptions of the switch substrate 100. Details are not described again.

As shown in FIG. 2, a packaged CPO chip is sent to a reflow soldering oven, and the reflow soldering oven can be heated to a high enough temperature (for example, higher than 260 degrees). A position to which the logic processing chip 102 extends out includes solder balls 202. When the solder balls 202 are in a high-temperature environment of the reflow soldering oven, the logic processing chip 102 can be soldered to the switch substrate 100 through the solder balls 202. Similarly, a position to which the photoelectric conversion apparatus 103 extends out includes solder balls 203. When the solder balls 203 are in the high-temperature environment of the reflow soldering oven, the photoelectric conversion apparatus 103 can be soldered to the switch substrate 100 through the solder balls 203. The photoelectric conversion apparatus 103 includes an optical chip and an electronic integrated circuit (electronic integrated circuit, EIC). The photoelectric conversion apparatus 103 includes an optical waveguide. The photoelectric conversion apparatus 103 is further connected to an optical fiber 110 shown in FIG. 1. The optical fiber 110 is coupled to the optical waveguide of the photoelectric conversion apparatus 103. If the photoelectric conversion apparatus 103 is configured to emit an optical signal, the EIC is configured to send a service electrical signal to the optical chip, and the optical chip is configured to convert the service electrical signal into a service optical signal. Because the optical waveguide is coupled to the optical fiber 110, and coupling means alignment or introduction, the optical signal can be transmitted between the optical waveguide and the optical fiber 110. For example, coupling between the optical waveguide and the optical fiber 110 means that the optical waveguide and the optical fiber 110 are in a state in which their end parts are connected. For another example, there is a gap between the optical waveguide and the optical fiber 110, and the optical signal is transmitted between the optical waveguide and the optical fiber 110 through the gap. This is not specifically limited, provided that the optical signal can be exchanged between the optical waveguide and the optical fiber 110 that are in a coupled state. In this case, the optical chip can couple the service optical signal to the optical fiber 110 to output the service optical signal from the photoelectric conversion apparatus 103. If the photoelectric conversion apparatus 103 is configured to receive the optical signal, the photoelectric conversion apparatus 102 is configured to receive a service optical signal through the optical fiber 110. The optical fiber 110 couples the service optical signal to an optical waveguide of the optical chip, the optical chip performs optical-to-electrical conversion on the service optical signal to obtain a service electrical signal, and the optical signal sends the service electrical signal to the EIC chip. It may be understood that a position at which the optical waveguide of the optical chip and the optical fiber are coupled to each other needs to withstand a high temperature in the reflow soldering oven, to prevent a case such as position shift and misalignment from occurring between the optical waveguide and the optical fiber at the high temperature in the reflow soldering oven. This increases an optical power loss between the optical waveguide and the optical fiber, and reduces coupling efficiency between the optical waveguide and the optical fiber.

In this embodiment, the switch substrate 100 may be connected to the PCB 201 via a socket 204, and a secure connection is formed between the switch substrate 100 and the PCB 201 through mechanical crimping. The switch substrate 100 is connected to the PCB 201 via the socket 204, so that when the photoelectric conversion apparatus 103 and the logic processing chip 102 are flip-chip soldered to the switch substrate 100, the packaged CPO chip does not need to be placed in the reflow soldering oven again for high-temperature soldering with the PCB 201. A connection manner between the switch substrate 100 and the PCB 201 is not limited in this embodiment. For example, the switch substrate 100 may alternatively be flip-chip soldered to the PCB 201 by using BGA.

This embodiment provides a photoelectric conversion apparatus. For a structure of the photoelectric conversion apparatus shown in this embodiment, refer to FIG. 3. FIG. 3 is an example diagram of a structure of a first embodiment of the photoelectric conversion apparatus according to this application. The photoelectric conversion apparatus 300 shown in FIG. 3 includes an optical chip 400 and an EIC. The photoelectric conversion apparatus 300 shown in this embodiment adopts a three-dimensional (3D) packaging mode. Specifically, the optical chip 400 is flip-chip soldered to a back surface of the EIC. There is an underfill (underfill) 304 between the optical chip 400 and the EIC. Solder balls 412 extending out from the optical chip 400 pass through the underfill 304 and are soldered to the back surface of the EIC. The solder balls shown in this embodiment may also be referred to as solder balls or solder bumps. This is not specifically limited. A front surface of the EIC is a surface that is of the EIC and on which an electrical connecting member is disposed. The back surface of the EIC is a surface that is of the EIC and that is opposite to the front surface of the EIC. The optical chip 400 is flip-chip soldered to the back surface of one EIC or back surfaces of a plurality of EICs. In this embodiment, an example in which the optical chip 400 is flip-chip soldered to back surfaces of two EICs, namely, an EIC 301 and an EIC 302, is used. A quantity of EICs to which one optical chip 400 is flip-chip soldered is not limited in this embodiment. The solder balls 203 extending out from the electrical connecting member of the EIC 301 are soldered to a switch substrate. For descriptions of the switch substrate, refer to the descriptions corresponding to FIG. 2. Details are not described again. The EIC 301 and the EIC 302 described in this embodiment are packaged as a whole through an injection molding layer 312. An electrical connecting member 313 passes through the injection molding layer 312. The injection molding layer 312 further includes a rewiring layer. The electrical connecting member 313 is electrically connected to an electrical connecting member of the optical chip 400 through the rewiring layer.

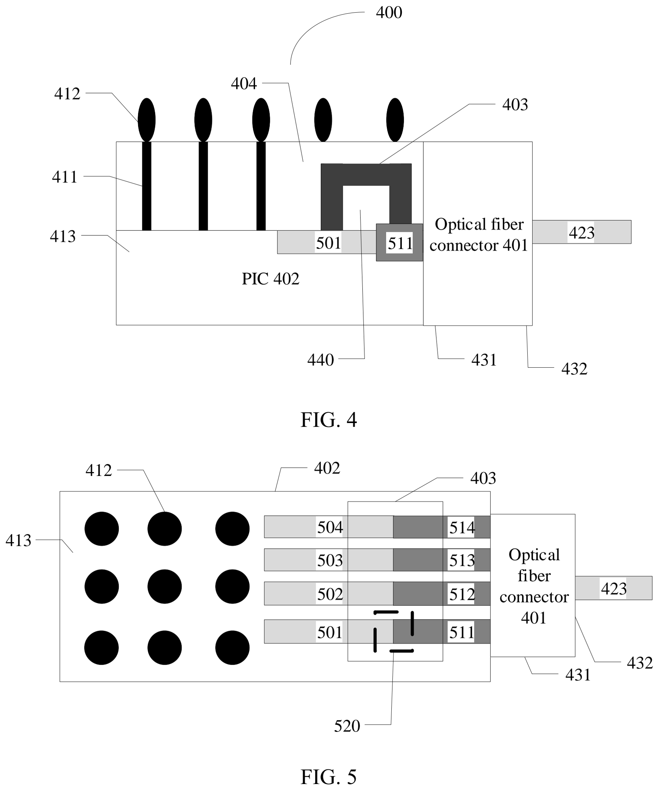

A coupling position between an optical waveguide and an optical fiber of the optical chip 400 provided in this embodiment can withstand a high temperature in a reflow soldering oven, to prevent a case such as position shift and misalignment from occurring at the high temperature. FIG. 4 is an example diagram of a structure of a first embodiment of the optical chip according to this application. FIG. 5 is an example top view of a structure of an embodiment of a part of optical chips according to this application. The optical chip 400 includes an optical fiber connector 401, a photonic integrated circuit (photonic integrated circuit, PIC) 402, a protective housing 403, and an injection molding layer 404. The top view shown in FIG. 5 is an example top view of a structure obtained after the injection molding layer 404 shown in FIG. 4 is removed.

A front surface 413 of the PIC 402 shown in this embodiment is configured to dispose an optical waveguide array. In this embodiment, an example in which a plurality of optical waveguides are arranged in the optical waveguide array is used. For example, in the example shown in FIG. 5, an optical waveguide 501, an optical waveguide 502, an optical waveguide 503, and an optical waveguide 504 are arranged in the optical waveguide array. A quantity of optical waveguides included in the optical waveguide array is not limited in this embodiment. Each optical waveguide may be made of any one of the following materials: monocrystalline silicon (silicon, Si), silicon nitride (silicon nitride, SiN) waveguide, and lithium niobate (lithium niobate, LiNbO3), a silicon oxide (silica, SiO2) waveguide, or the like. The PIC 402 includes an electrical-to-optical converter and an optical-to-electrical converter. A part of optical waveguides included in the optical waveguide array are connected to the electrical-to-optical converter, and the other part of optical waveguides are connected to the optical-to-electrical converter. For example, the optical waveguide 501 and the optical waveguide 502 are connected to the electrical-to-optical converter, while the optical waveguide 503 and the optical waveguide 504 are connected to the optical-to-electrical converter. The PIC 402 shown in this embodiment has an electrical connecting member 411, and the electrical connecting member 411 extends out from the front surface of the PIC 402 to form the solder balls 412. The front surface of the PIC 402 is a surface that is of the PIC and on which the optical waveguide is disposed. For example, the solder balls 412 located between the EIC 301 and the optical chip 400 are configured to transmit an electrical signal between the optical chip 400 and the EIC 301, and the solder balls 412 located between the EIC 302 and the optical chip 400 are configured to transmit an electrical signal between the optical chip and the EIC 302.

The optical fiber connector 401 in this embodiment includes an optical fiber array. As shown in FIG. 5, the optical fiber array is configured to be coupled to the optical waveguide array of the optical chip. For example, an optical fiber 511 included in the optical fiber array is coupled to the optical waveguide 501 of the optical chip, an optical fiber 512 included in the optical fiber array is coupled to the optical waveguide 502 of the optical chip, an optical fiber 513 included in the optical fiber array is coupled to the optical waveguide 503 of the optical chip, and an optical fiber 514 included in the optical fiber array is coupled to the optical waveguide 504 of the optical chip. A quantity of optical fibers included in the optical fiber array is not limited in this embodiment. The optical fiber connector 401 shown in this embodiment may be an optical fiber connector of a multi-fiber push on (multi-fiber push on, MPO) type, an optical fiber connector of a ferrule connector (ferrule connector, FC) type, an optical fiber connector of a square connector (square connector, SC) type, an optical fiber connector of a lucent connector (lucent connector, LC) type, an optical fiber connector of a straight tip (straight tip, ST) type, an optical fiber connector of a fiber distributed data interface (fiber distributed data interface, FDDI) type, or the like. A specific type is not limited.

It may be understood that the optical fiber connector 401 has a first connection end 431 that faces the PIC 402 and a second connection end 432 that is away from the PIC. A first coupling end of each optical fiber included in the optical fiber array passes through the first connection end 431, to couple to the optical waveguide in the optical waveguide array. For example, the first coupling end of the optical fiber 511 passes through the first connection end 431, to couple to the optical waveguide 501. In this embodiment, the first connection end 431 of the optical fiber connector 401 and the PIC 402 abut against each other, so that the optical fiber connector 401 can be connected to the PIC 402 when the injection molding layer 404 is deposited on the front surface 413 of the PIC. That is, the optical fiber connector 401 shown in this embodiment is integrated onto the PIC 402 by using an injection molding process.

The optical waveguide 501 and the optical fiber 511 are used as examples. To couple the optical waveguide 501 to the optical fiber 511, and further transmit an optical signal between the optical waveguide 501 and the optical fiber 511, the first coupling end of the optical fiber 511 is coupled to a second coupling end of the optical waveguide 501. The protective housing 403 included in the optical chip shown in this embodiment is configured to ensure a coupling position between the first coupling end of the optical fiber 511 and the second coupling end of the optical waveguide 501. In this way, the injection molding layer 404 formed by using the injection molding process can damage the coupling position between the first coupling end of the optical fiber 511 and the second coupling end of the optical waveguide 501. This prevents a case such as position shift and misalignment from occurring on the optical fiber 511 and/or the optical waveguide 501 in the injection molding process, which may result in a reduction in coupling efficiency between the optical fiber 511 and the photoelectric conversion apparatus 501. Specifically, coupling space 440 is formed between the protective housing 403 and the PIC 402. For example, a concave cavity is disposed on the protective housing 403, and a cavity opening of the concave cavity is disposed facing the PIC 402, so that the coupling space 440 is formed between the concave cavity and the PIC 402. For example, as shown in FIG. 5, the first coupling end of the optical fiber 511 and the second coupling end of the optical waveguide 501 shown in this embodiment both extend into the coupling space 440, and the first coupling end of the optical fiber 511 and the second coupling end of the optical waveguide 501 are coupled in a region 520. That the first coupling end of the optical fiber 511 and the second coupling end of the optical waveguide 501 that extend into the coupling space 440 are coupled means that an axial center of the first coupling end that extends into the coupling space 440 is aligned with an axial center of the optical waveguide 501. For another example, the axial center of the first coupling end extending into the coupling space 440 and the axial center of the optical waveguide 501 are located on a same straight line. The first coupling end and the second coupling end shown in this embodiment may be connected to each other. For another example, there may be a specific gap between the first coupling end and the second coupling end. A size of the gap is not limited in this embodiment, provided that an optical signal output by the first coupling end can be coupled to the second coupling end through the gap, or an optical signal output by the second coupling end can be coupled to the first coupling end through the gap.

When the first coupling end and the second coupling end are coupled, coupling efficiency between the first coupling end and the second coupling end can be ensured, and a reduction in coupling efficiency between the first coupling end and the second coupling end is avoided as much as possible. Coupling efficiency between the first coupling end and the second coupling end is a ratio of an optical power Pa of an optical signal that is emitted from the second coupling end and that is incident to the first coupling end to a total optical power Pb of the optical signal emitted from the second coupling end, that is, coupling efficiency=Pa/*Pb*.

The electrical connecting member 411 of the PIC passes through the injection molding layer 404, to form the solder balls 412, for being soldered to the EIC, on a surface of the injection molding layer 404. In addition, the optical chip 400 is soldered inside the photoelectric conversion apparatus in a flip-chip soldering manner based on the electrical connecting member 411.

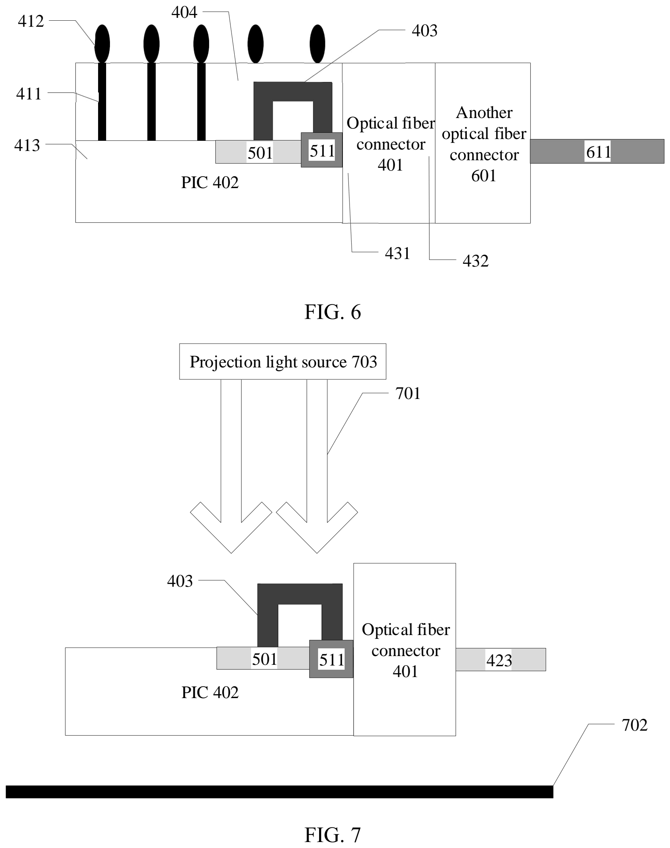

FIG. 6 is an example diagram of connecting the optical fiber connector of the optical chip according to this application to another optical fiber connector. The second connection end 432 of the optical fiber connector 401 shown in this embodiment is configured to detachably connect to another optical fiber connector 601. For example, the second connection end 432 of the optical fiber connector 401 has a positioning pin 423, and the another optical fiber connector 601 has a positioning hole. When the positioning pin 423 is inserted into the positioning hole, the optical fiber array of the optical fiber connector 401 is connected to a link optical fiber array of the another optical fiber connector 601. For example, when the optical fiber connector 401 is detachably connected to the another optical fiber connector 601, a link optical fiber 611 included in the link optical fiber array is connected to the optical fiber 511 of the optical fiber connector 401, to transmit an optical signal between the optical fiber connector 401 and the another optical fiber connector 601. The other end of the link optical fiber 611 is connected to another optical chip, to transmit an optical signal between two different optical chips through the link optical fiber 611. A detachable connection manner between the optical fiber connector 401 and the another optical fiber connector 601 is not limited in this embodiment. For example, the positioning hole may be disposed at the second connection end of the optical fiber connector 401, and the positioning pin may be disposed on the another optical fiber connector, so that the optical fiber connector 401 is detachably connected to the another optical fiber connector. The optical fiber connector 401 and the another optical fiber connector 601 in this embodiment may be packaged as a whole by using a plastic packaging process, and the positioning pin and the positioning hole are disposed at positions that are on the optical fiber connector 401 and the another optical fiber connector 601 and that are opposite to each other. After the packaging is completed, the optical fiber connector 401 and the another optical fiber connector 601 are separated from each other, to ensure that the positioning pin of the optical fiber connector 401 and the positioning hole of the another optical fiber connector 601 are in a clean and uncontaminated state.

It can be learned from the descriptions of the structure of the photoelectric conversion apparatus that the photoelectric conversion apparatus shown in this embodiment adopts 3D packaging. That is, the PIC is flip-chip soldered on the EIC. Consequently, a packaging size of the photoelectric conversion apparatus is reduced, and an integration level of the photoelectric conversion apparatus is improved. The PIC is soldered on the EIC in the flip-chip soldering manner, and the EIC is also soldered to the switch substrate in the flip-chip soldering manner. This effectively reduces a distance between the PIC and the EIC, and reduces a distance between the logic processing chip and the EIC, thereby effectively reducing power consumption of the photoelectric conversion apparatus. The optical fiber connector of the optical chip and the another optical fiber connector are in a detachable connection state. In this case, in a process of flip-chip soldering the optical chip, the optical fiber connector and the another optical fiber connector may be in a separated state. The link optical fiber array that has a considerable length and that is connected to the another optical fiber connection does not cause operation interference to the flip-chip soldering process of the optical chip. This improves operation efficiency of flip-chip soldering the optical chip.

The coupling position between the optical waveguide of the PIC and the optical fiber of the optical fiber connector is located in the coupling space formed between the protective housing and the PIC. Therefore, this effectively prevents the injection molding layer formed by using the injection molding process from damaging the coupling position between the first coupling end of the optical fiber and the second coupling end of the optical waveguide. In this way, the axial center of the first coupling end is always in a state of being aligned with the axial center of the second coupling end, which effectively ensures coupling efficiency between the first coupling end of the optical fiber and the second coupling end of the optical waveguide.

The coupling position between the second coupling end of the optical waveguide and the first coupling end of the optical fiber shown in this embodiment does not need to be fastened through optical glue. This prevents a case of position shift because of a high temperature or position misalignment because of a high temperature from occurring on the second coupling end of the optical waveguide and/or the first coupling end of the optical fiber when the photoelectric conversion apparatus is placed in a high-temperature environment of a reflow soldering oven. Therefore, for the optical chip shown in this embodiment, high-precision coupling between the first coupling end and the second coupling end can be kept even in the high-temperature environment of the reflow soldering oven.

As shown in FIG. 2, when the photoelectric conversion apparatus 103 is packaged but is not flip-chip soldered to the switch substrate 100, the photoelectric conversion apparatus 102 has a test interface, and an external test device may be connected to the test interface of the photoelectric conversion apparatus 103. For example, the external test device may send an optical signal to the photoelectric conversion apparatus 103 through the test interface of the photoelectric conversion apparatus 103, to test whether the optical signal can successfully receive the optical signal and perform optical-to-electrical conversion on the optical signal. For another example, the external test device may receive an optical signal from the photoelectric conversion apparatus 103 through the test interface of the photoelectric conversion apparatus 103. The external test device can test whether the packaged photoelectric conversion apparatus 103 can normally receive and send an optical signal. If the photoelectric conversion apparatus 103 can normally receive and send the optical signal, the external test device determines that the photoelectric conversion apparatus 103 is a known good die (known good die, KGD). Then, the photoelectric conversion apparatus 103 is flip-chip soldered to the switch substrate 100, and is placed in the reflow soldering oven to complete the soldering. It may be understood that the photoelectric conversion apparatus 103 is soldered to the switch substrate 100 only when it is determined that the photoelectric conversion apparatus 103 is the KGD. This improves a product yield of the optical communication device.

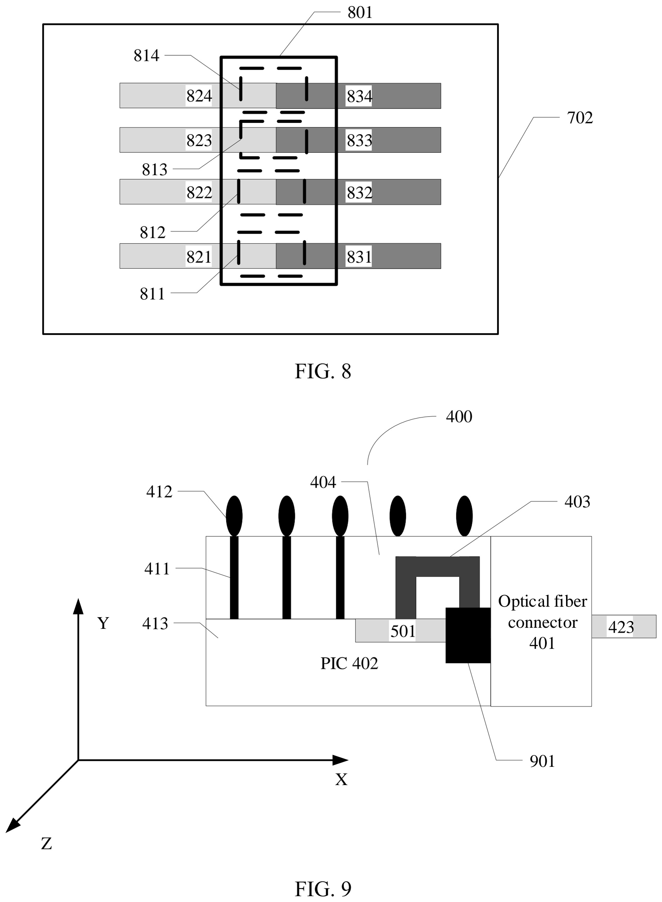

FIG. 7 is an example projection diagram of an embodiment of a part of optical chips according to this application. It should be noted that a projection scenario example shown in this embodiment describes a position relationship between the optical waveguide, the optical fiber, and the protective housing, and the optical chip is not necessarily placed in a projection environment shown in this embodiment. The projection environment includes a projection plane 702. A projection light source 703 is disposed on the projection plane 702. The projection light source 703 can emit a plurality of projection rays 701 that are parallel to each other. Each projection ray emitted from the projection light source 703 is perpendicular to the projection plane 702. The optical chip shown in this embodiment is located between the projection light source 703 and the projection plane 702. To better reflect a position relationship between the optical waveguide array and the optical fiber array of the optical chip, an example in which the optical chip from which the injection molding layer is removed and that is located between the projection light source 703 and the projection plane 702 is used. Each projection ray 701 shown in this embodiment is perpendicular to a surface that is of the PIC and that includes the optical waveguide array. It may be understood that each projection ray 701 is incident, in the direction perpendicular to the surface of the PIC, to the protective housing 403 and a coupling position between the optical waveguide array and the optical fiber array. In this case, when the plurality of projection rays 701 are illuminated on the optical chip, an orthographic projection shown in FIG. 8 is formed on the projection plane 702. FIG. 8 is an example diagram of the orthographic projection shown in FIG. 7. Specifically, when the projection rays 701 are irradiated on the protective housing 403, a fourth orthographic projection 801 can be obtained on the projection plane 702. When the projection rays 701 are irradiated on the optical waveguide 501, the optical waveguide 502, the optical waveguide 503, and the optical waveguide 504 in the optical waveguide array, an optical waveguide orthographic projection 821, an optical waveguide orthographic projection 822, an optical waveguide orthographic projection 823, and an optical waveguide orthographic projection 824 are formed on the projection plane 702, respectively. When the projection rays 701 are irradiated on the optical fiber 511, the optical fiber 512, the optical fiber 513, and the optical fiber 514 in the optical fiber array, an optical fiber orthographic projection 831, an optical fiber orthographic projection 832, an optical fiber orthographic projection 833, and an optical fiber orthographic projection 834 are formed on the projection plane 702, respectively. In addition, a coupling position is formed at a position at which the second coupling end of the optical waveguide 501 and the first coupling end of the optical fiber 511 are coupled to each other. When the projection rays 701 are irradiated at the coupling position, a third orthographic projection 811 can be formed on the projection plane 702. It may be understood that the third orthographic projection 811 is a position at which the optical waveguide orthographic projection 821 is coupled to the optical fiber orthographic projection 831. Similarly, a third orthographic projection 812 is a position at which the optical waveguide orthographic projection 822 is coupled to the optical fiber orthographic projection 832. A third orthographic projection 813 is a position at which the optical waveguide orthographic projection 823 is coupled to the optical fiber orthographic projection 833. A third orthographic projection 814 is a position at which the optical waveguide orthographic projection 824 is coupled to the optical fiber orthographic projection 834. The third orthographic projection 811, the third orthographic projection 812, the third orthographic projection 813, and the third orthographic projection 814 shown in this example are all located within coverage of the fourth orthographic projection 801. With reference to FIG. 6 to FIG. 8, it can be learned that because each third orthographic projection is within the coverage of the fourth orthographic projection, it indicates that a coupling position between each pair of optical waveguide and optical fiber is within a protection range of the protective housing 403. In this case, the injection molding layer does not damage the coupling position between the optical waveguide and the optical fiber, which ensures coupling efficiency between the optical waveguide and the optical fiber.

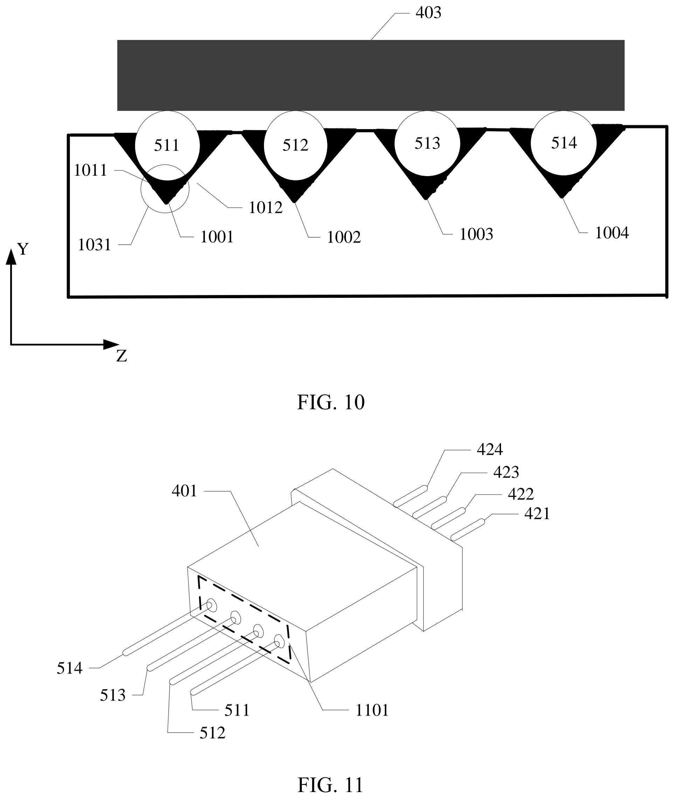

It can be learned from the foregoing that to ensure coupling efficiency between the optical waveguide array and the optical fiber array, it needs to be ensured that the axial center of the second coupling end of the optical waveguide is aligned with the axial center of the first coupling end of the optical fiber. The following describes a manner in which the optical chip shown in this embodiment effectively ensures that the axial center of the second coupling end of the optical waveguide is aligned with the axial center of the first coupling end of the optical fiber. Refer to FIG. 9 and FIG. 10. FIG. 9 is an example diagram of a structure of the optical chip in a first plane according to this application. FIG. 10 is an example diagram of the structure of the optical chip in a second plane according to this application. A first plane XY shown in this embodiment includes a first direction X and a second direction Y. The first direction X is perpendicular to the second direction Y, and the second direction Y is perpendicular to the surface of the PIN 402. A second plane YZ includes the second direction Y and a third direction Z. The third direction Z is separately perpendicular to the first direction X and the second direction Y.

For specific descriptions of the optical chip shown in FIG. 9, refer to the descriptions shown in FIG. 4. Details are not described again. A difference between the optical chip shown in FIG. 9 and that shown in FIG. 4 lies in that in the embodiment shown in FIG. 9, the PIC 402 of the optical chip has a groove array 901. Specifically, the groove array 901 is concavely disposed on a surface that is of the PIC 402 and that faces the protective housing 403. The groove array 901 includes a plurality of grooves. A quantity of grooves included in the groove array 901 is the same as a quantity of optical fibers included in the optical fiber array. With reference to the foregoing example, the groove array 901 shown in this embodiment includes four grooves: a groove 1001, a groove 1002, a groove 1003, and a groove 1004. The groove 1001, the groove 1002, the groove 1003, and the groove 1004 are respectively configured to fasten the optical fiber 511, the optical fiber 512, the optical fiber 513, and the optical fiber 514. The groove 1001 is used as an example. The groove 1001 has a first side wall 1011 and a second side wall 1012 that are at opposite positions. The second coupling end of the optical fiber 511 separately abuts against the first side wall 1011 and the second side wall 1012. There is a groove opening at a position that is of the groove 1001 and that faces the protective housing 403, and the protective housing 403 covers the groove opening, so that the first coupling end of the optical fiber 511 further abuts against the protective housing 403. For descriptions of a structure of any groove included in the groove array shown in this embodiment, refer to the descriptions of the groove 1001. Details are not described again.

It may be understood that a position of the first coupling end of the optical fiber 511 shown in this embodiment is jointly limited by the protective housing 403, and the first side wall 1011 and the second side wall 1012 of the groove 1001, so that the position of the first coupling end of the optical fiber 511 cannot be shifted in the third direction Z, or cannot be shifted in the second direction Y. In this case, even if the optical chip is in a packaging process, in the reflow soldering oven, or in an in-use state after packaging is completed, the state in which the axial center of the second coupling end of the optical waveguide 501 is always aligned with the axial center of the first coupling end of the optical fiber 511 located in the groove 1001 is kept. That is, the groove 1001 can implement high-precision coupling between the second coupling end of the optical waveguide 501 and the first coupling end of the optical fiber 511. This ensures coupling efficiency between the optical waveguide 501 and the optical fiber 511, and reduces an optical power loss between the optical waveguide 501 and the optical fiber 511.

To increase a limitation of the groove 1001 on the position of the first coupling end of the optical fiber 511 and avoid the position shift of the first coupling end of the optical fiber 511, as shown in this embodiment, glue may be deposited between a groove bottom (as shown in a region 1031 shown in FIG. 10) of the groove 1001 and the first coupling end of the optical fiber 511. In this way, after the glue is cured, the position of the first coupling end of the optical fiber 511 is jointly limited by the cured glue, the first side wall 1011 and the second side wall 1012 of the groove 1001, and the protective housing 403. This ensures that the groove 1001 can securely fasten the first coupling end of the optical fiber 511, and ensures that the axial center of the second coupling end of the optical waveguide 501 is always in the state of being aligned with the axial center of the first coupling end of the optical fiber 511 located in the groove 1001. In this embodiment, an example the glue deposited at the groove bottom of the groove 1001 is mechanical glue is used as an example, so that even in the high-temperature environment of the reflow soldering oven, the cured glue can still securely fasten the position of the first coupling end of the optical fiber 511. The glue deposited in the groove 1001 shown in this embodiment may also overflow and fill the entire groove 1001.

Because the groove 1001 limits the position of the first coupling end of the optical fiber 511, the axial center of the second coupling end of the optical waveguide 501 is always in the state of being aligned with the axial center of the first coupling end of the optical fiber 511. In this case, the second coupling end of the optical waveguide 501 and the first coupling end of the optical fiber 511 do not need to be fastened through the glue. This effectively prevents a case, occurred because the glue cannot withstand the high temperature, such as position misalignment and shift from occurring between the second coupling end of the optical waveguide 501 and the first coupling end of the optical fiber 511 in the reflow soldering oven. This reduces coupling efficiency between the optical waveguide 501 and the optical fiber 511.

A specific shape of the groove 1001 in the second plane YZ is not limited in this embodiment. For example, the groove 1001 may be in a U shape in the second plane YZ. In this case, a connection between the first side wall 1011 and the second side wall 1012 of the groove 1001 is in an arc shape. In this embodiment, the groove 1001 is in a V shape in the second plane YZ. In this case, an included angle between the first side wall 1011 and the second side wall 1012 of the groove 1001 is an acute angle. When each groove included in the groove array shown in this embodiment is in the V shape in the second plane YZ, in the third direction Z in the second plane YZ, the quantity of grooves per unit length can be effectively increased, which effectively increases the quantity of optical fibers included in the optical chip, and improves density of the optical fibers. For example, when the groove array is disposed, the optical fiber array is fastened by using the groove array, so that in the second plane YZ, a distance between first coupling ends of two adjacent optical fibers in the optical fiber array can be approximately 2 microns.

Refer to FIG. 9 to FIG. 11. FIG. 11 is an example diagram of a structure of an embodiment of the optical fiber connector according to this application. In this embodiment, there is an array port 1101 on an end face that is of the optical fiber connector 401 and that faces the PIC 402. The first coupling end of each optical fiber in the optical fiber array extends out from the array port 1101, to be coupled to the optical waveguide array. The optical fiber connector 401 is connected to the PIC 402. To ensure that the first coupling end that is of the optical fiber array and that extends out from the optical fiber connector 401 can be coupled to the optical waveguide array, in this example, the array port 1101 and the optical waveguide array are in the first plane XY and have a same height. In this case, an example in which the first coupling end that is of the optical fiber array and that extends out from the array port 1101 is of a straight-line structure in the first plane XY is used.

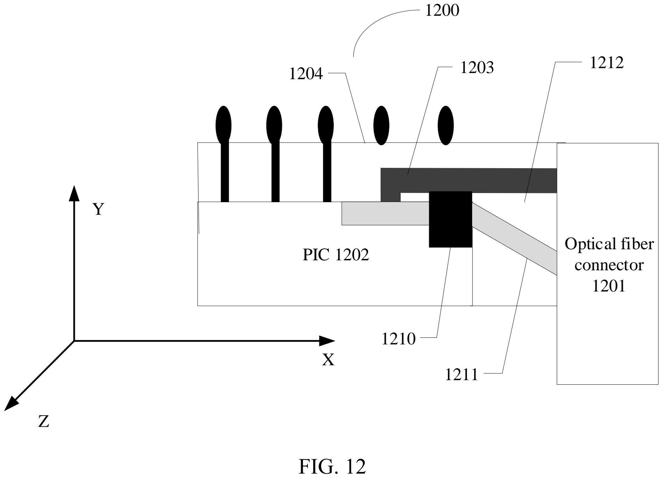

In the foregoing embodiment, an example in which the optical fiber connector is connected to the PIC is used. In this embodiment, there may be a specific gap between the optical fiber connector and the PIC, and the array port on the optical fiber connector and the optical waveguide array have different heights in the first plane XY. Refer to FIG. 12. FIG. 12 is another example diagram of another structure of the optical chip in the first plane according to this application. For descriptions of an optical fiber connector 1201, a PIC 1202, a protective housing 1203, an injection molding layer 1204, and an optical waveguide array that are included in the optical chip 1200 shown in this embodiment, and an electrical connecting member included in the optical chip 1204, refer to the foregoing embodiment. Details are not described again.

There is a gap 1212 between the optical fiber connector 1201 and the PIC 1202 shown in this embodiment, so that the injection molding layer 1204 can be deposited in the gap 1212 between the PIC 1202 and the optical fiber connector 1201, to ensure that the optical fiber connector 1201 is connected to the PIC 1202. A groove 1210 is formed on the PIC 1202 shown in this embodiment. The groove 1210 is configured to fasten a first coupling end that is of an optical fiber and that extends out from the optical fiber connector 1201. For descriptions of a structure of the groove 1210, refer to FIG. 9 and FIG. 10. Details are not described again. The optical fiber that extends out from the optical fiber connector 1201 and that is shown in this embodiment specifically includes the first coupling end located in the groove and a connection section 1211 that is connected between the first coupling end and the optical fiber connector 1201. The groove 1210 is configured to fasten the first coupling end of the optical fiber. The connection section 1211 of the optical fiber extends out from the optical fiber connector 1201 and crosses the gap 1212, so that the first coupling end of the optical fiber extends into the groove 1210. This ensures that an axial center of the first coupling end of the optical fiber is aligned with an axial center of a second coupling end of an optical waveguide. A shape of the connection section 1211 that is of the optical fiber and that crosses the gap 1212 is not limited in this embodiment.

There is an array port on an end face that is of the optical fiber connector 1201 and that faces the PIC 1202 in this embodiment. For descriptions of the array port, refer to FIG. 11. Details are not described again. In addition, in this example, the array port and the optical waveguide array have different heights in the first plane XY. Specifically, in this example, the height of the optical waveguide array is higher than the height of the array port in the first plane XY. In this case, if the connection section that extends out from the optical fiber connector 1201 is of a straight-line structure, the first coupling end cannot extend into the groove 1210. In view of this, the connection section 1211 crossing the gap 1212 needs to extend in a direction toward a surface of the PIC 1202, until the first coupling end of the optical fiber can extend into the groove 1210. For example, the array port and the optical waveguide array shown in this embodiment have different heights in the first plane XY. In this case, a step may be formed between the optical fiber connector 1201 and the PIC 1202. Optionally, a carrier plate may be disposed at a position of the step. In the first direction X, a length of the carrier plate is equal to a length of the PIC 1202 and a length of the gap 1212. In the second direction Y, the length of the carrier plate is equal to a length of the step.

It may be understood that the first coupling end that is of the optical fiber and that extends out from the optical fiber connector 1201 can extend into the groove 1210 through the gap between the optical fiber connector 1201 and the PIC 1202. However, because there is the gap 1212 between the optical fiber connector 1201 and the PIC 1202, the injection molding layer is formed in the gap 1212 by using an injection molding process. The protective housing 1203 shown in this embodiment can further protect the optical fiber to avoid the following case: The injection molding layer formed in the gap 1212 applies an excessively large acting force on the connection section 1211 of the optical fiber, which causes the optical fiber to break or causes position shift of the first coupling end, and consequently, an axial center of the first coupling end cannot be aligned with an axial center of the second coupling end, which reduces coupling efficiency, and even causes an optical signal to be unable to be communicated between the optical waveguide array and the optical fiber array. Specifically, the protective housing 1203 extends, toward an end part of the optical fiber connector 1201, into a position at which the protective housing 1203 abuts against the optical fiber connector 1201, so that the protective housing 1203 reduces a thickness of the injection molding layer 1212 deposited on the connection section 1211 of the optical fiber, and the acting force applied by the injection molding layer 1212 on the connection section 1211 of the optical fiber is further reduced. This effectively avoids a case in which the connection section 1211 of the optical fiber is broken, and avoids a case in which the connection section 1211 of the optical fiber causes position shift to the first coupling end under the acting force applied by the injection molding layer. The protective housing 1203 can ensure that the axial center of the first coupling end is always in a state of being aligned with the axial center of the second coupling end, which ensures coupling efficiency between the first coupling end and the second coupling end.

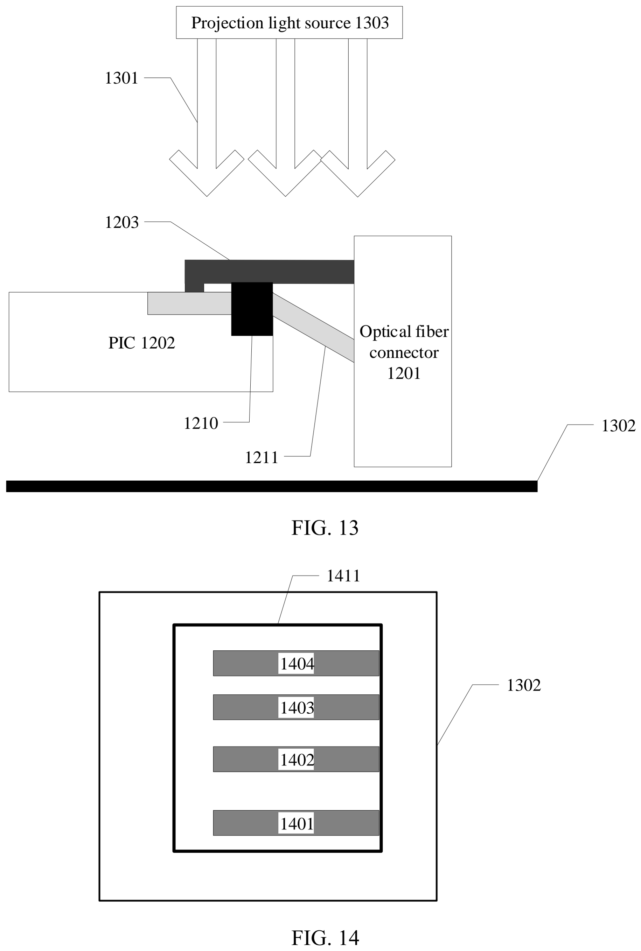

For better understanding, refer to FIG. 13. FIG. 13 is an example projection diagram of another embodiment of a part of optical signals according to this application. It should be noted that a projection scenario example shown in this embodiment describes a position relationship between the protective housing and the optical fiber array that are included in the optical chip, and the optical chip is not necessarily placed in a projection environment shown in this embodiment. The projection environment includes a projection plane 1302. A projection light source 1303 is disposed on the projection plane 1302. The projection light source 1303 can emit a plurality of projection rays 1301 that are parallel to each other. Each projection ray emitted from the projection light source 1303 is perpendicular to the projection plane 1302. The optical chip shown in this embodiment is located between the projection light source 1303 and the projection plane 1302. To better reflect the position relationship between the optical fiber array and the protective housing, an example in which the optical chip from which the injection molding layer is removed and that is located between the projection light source 1303 and the projection plane 1302 is used. Each projection ray 1301 shown in this embodiment is perpendicular to a surface that is of the PIC and that is configured to dispose the optical waveguide array. It may be understood that each projection ray 1301 is incident to the optical fiber array and the protective housing 1203 in the direction perpendicular to the surface of the PIC. In this case, when the plurality of projection rays 1301 are illuminated on the optical chip, an orthographic projection shown in FIG. 14 is formed on the projection plane 1302. FIG. 14 is an example diagram of the orthographic projection shown in FIG. 13. Specifically, when the projection rays 1301 are irradiated on the connection section of the optical fiber, a first orthographic projection can be obtained on the projection plane 1302. For example, there are four optical fibers extending out from the optical fiber connector. When the projection rays 1301 are irradiated on connection sections of the four optical fibers, a first orthographic projection 1401, a first orthographic projection 1402, a first orthographic projection 1403, and a first orthographic projection 1404 that respectively correspond to the connection sections of the four optical fibers are obtained. When the projection rays 1301 are irradiated on the protective housing 1203, a second orthographic projection 1411 can be obtained on the projection plane 1302. Each first orthographic projection shown in this embodiment is located within coverage of the second orthographic projection 1411. In this embodiment, an example in which the first orthographic projection is completely located within the coverage of the second orthographic projection is used. In another example, the first orthographic projection may alternatively be partially located within the coverage of the second orthographic projection. The protective housing 1203 shown in this embodiment can further protect a coupling position between the optical fiber array and the optical waveguide array. For specific protection descriptions, refer to FIG. 7 and FIG. 8. Details are not described again. In this embodiment, an example in which the height of the optical waveguide array is higher than the height of the array port in the first plane XY is used. In another example, the height of the optical waveguide array may be equal to the height of the array port in the first plane XY, or the height of the optical waveguide array may be lower than the height of the array port, provided that the connection section of the optical fiber can pass through the gap between the optical fiber connector and the PIC, so that the first coupling end connected to the connection section can extend into the groove 1210, to ensure that the axial center of the first coupling end of the optical fiber is aligned with the axial center of the second coupling end of the optical waveguide.

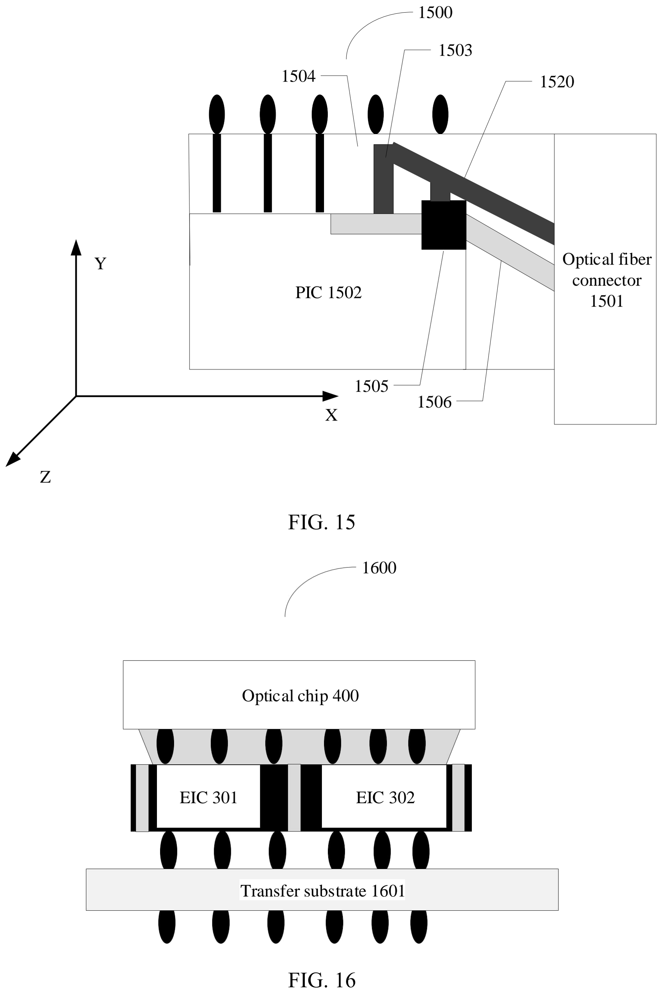

In the example shown in FIG. 12, an example in which the end part of the optical fiber connector 1201 connected to the protective housing 1203 is of a straight-line structure in the first direction X is used. In the embodiment shown in FIG. 15, protection effect of the protective housing on the connection section of the optical fiber can be further improved on a basis of FIG. 12. FIG. 15 is an example diagram of another structure of the optical chip in the first plane according to this application. The optical chip 1500 shown in this embodiment includes an optical fiber connector 1501, a PIC 1502, a groove 1505, a connection section 1506 of an optical fiber, and an injection molding layer 1504. For details, refer to FIG. 12. Details are not described again. The protective housing 1503 shown in this embodiment has an extension section 1520. The extension section 1520 crosses a coupling position between the optical fiber array and the optical waveguide array, and the optical fiber array, until the extension section abuts against a side surface that is of the optical fiber connector 1501 and that faces the PIC 1502.

In this embodiment, in the direction perpendicular to the surface of the PIC (that is, in the second direction Y), there is a first distance H1 between the extension section 1520 of the protective housing and the coupling position, and there is a second distance H2 between the connection section 1506 of the optical fiber and the extension section 1520 of the protective housing 1503. The second distance H2 is not greater than the first distance H1. It may be understood from FIG. 15 that a structure of the extension section 1520 shown in this embodiment tilts in a direction toward a port array on the optical fiber connector 1501, to ensure that the second distance H2 is not greater than the first distance H1. It can be learned by comparing the examples shown in FIG. 12 and FIG. 15 that the extension section 1520 of the protective housing 1503 shown in this embodiment can reduce a thickness of the injection molding layer deposited on the connection section 1506. This effectively reduces an action force applied by the injection molding layer on the connection section 1506, and ensures coupling efficiency between the optical fiber array and the optical waveguide array.

The following describes optional structures of the photoelectric conversion apparatus.

### Optional structure 1

For the structure that is of the photoelectric conversion apparatus and that is shown in this example, refer to FIG. 3. For details, refer to the embodiment corresponding to FIG. 3. Details are not described again. The solder balls led out from the EIC of the photoelectric conversion apparatus shown in this embodiment are directly soldered to the switch substrate 100 shown in FIG. 2, to communicate an electrical signal with the logic processing chip 102.

### Optional structure 2

For the structure that is of the photoelectric conversion apparatus and that is shown in this example, refer to FIG. 16. FIG. 16 is an example diagram of a structure of a second embodiment of the photoelectric conversion apparatus according to this application. The photoelectric conversion apparatus includes a transfer substrate 1601, the EIC 301, the EIC 302, and the optical chip 400. For descriptions of structures of the EIC 301, the EIC 302, and the optical chip 400, refer to the foregoing embodiments. Details are not described again. Each EIC is flip-chip soldered to the transfer substrate 1601, and the optical chip 400 is flip-chip soldered to a side surface that is of the EIC and that is away from the transfer substrate 1601. The transfer substrate 1601 shown in this embodiment is soldered to the switch substrate 100 shown in FIG. 2 by using the BGA, to communicate an electrical signal between the photoelectric conversion apparatus and the logic processing chip 102. The optical chip 400 and each EIC that are shown in this embodiment both communicate an electrical signal through the transfer substrate 1601. For descriptions of electrical signal conduction implemented by the transfer substrate 1601 shown in this example, refer to the descriptions of the switch substrate in the embodiment corresponding to FIG. 1. Details are not described again. The transfer substrate 1601 shown in this embodiment has a test interface. An external test device may test whether the photoelectric conversion apparatus is a KGD through the test interface. For descriptions of testing the photoelectric conversion apparatus by the external test device, refer to the embodiment corresponding to FIG. 2. Details are not described herein again.

### Optional structure 3

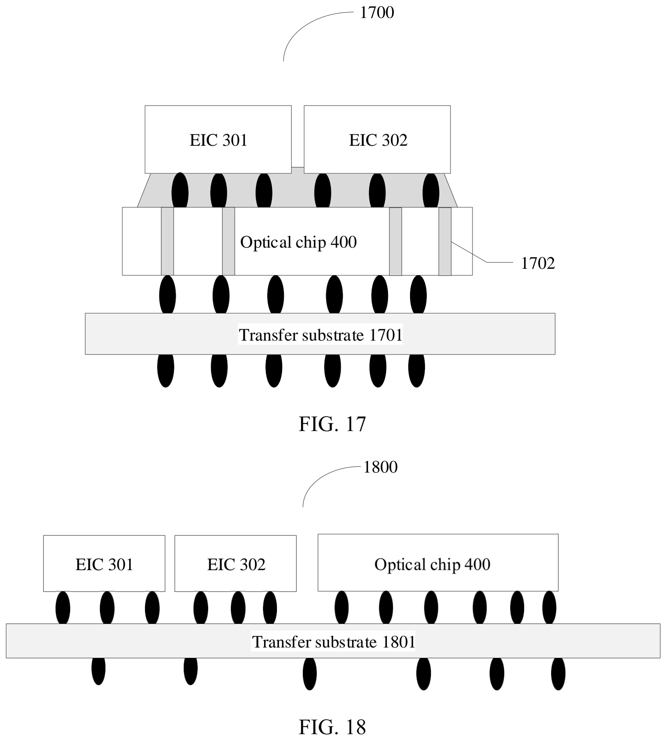

The photoelectric conversion apparatus shown in this example is also packaged in a 3D manner. For details, refer to FIG. 17. FIG. 17 is an example diagram of a structure of a third embodiment of the photoelectric conversion apparatus according to this application.

The photoelectric conversion apparatus shown in this example includes the optical chip 400 and two EICs, for example, the EIC 301 and the EIC 302. A quantity of EICs included in the photoelectric conversion apparatus is not limited in this example. Each EIC included in the photoelectric conversion apparatus is flip-chip soldered to the optical chip 400. That is, solder balls led out from the EIC are soldered to the optical chip 400. The optical chip 400 is flip-chip soldered to a switch substrate. For descriptions of the switch substrate, refer to FIG. 2. Details are not described again. It may be understood that the EIC shown in this embodiment is flip-chip soldered to a side surface that is of the optical chip and that is away from the switch substrate. Packaging of the optical chip 400 shown in this embodiment further includes a through silicon via (through silicon via, TSV) 1702. The EIC is electrically connected to the switch substrate through the TSV 1702.

Optionally, the photoelectric conversion apparatus in this example further includes a transfer substrate 1701. The optical chip 400 in this example is flip-chip soldered to the transfer substrate 1701. In this case, each EIC is flip-chip soldered to a side surface that is of the optical chip 400 and that is away from the transfer substrate 1701. The transfer substrate 1701 shown in this example is soldered to the switch substrate 100 shown in FIG. 2 by using the BGA, to communicate an electrical signal with the logic processing chip 102. The optical chip 400 and each EIC that are shown in this example communicate an electrical signal through the transfer substrate 1701. The EIC is electrically connected to the transfer substrate 1701 through the TSV 1702 of the optical chip 400. The transfer substrate 1701 shown in this embodiment has a test interface. An external test device may test whether the photoelectric conversion apparatus is a KGD through the test interface. For descriptions of testing the photoelectric conversion apparatus by the external test device, refer to the embodiment corresponding to FIG. 2. Details are not described herein again.

Optionally, the photoelectric conversion apparatus shown in this embodiment may not include the transfer substrate 1701, and solder balls led out from the optical chip are directly flip-chip soldered to the switch substrate 100 shown in FIG. 2. Details are not described herein again.

The optional structure 1 to the optional structure 3 all use 3D packaging which can improve density of a packaged optical fiber array, reduce an overall packaging size of the photoelectric conversion apparatus, and improve an integration level of the photoelectric conversion apparatus.

### Optional structure 4

For the structure that is of the photoelectric conversion apparatus and that is shown in this example, refer to FIG. 18. FIG. 18 is an example diagram of a structure of a fourth embodiment of the photoelectric conversion apparatus according to this application.

The photoelectric conversion apparatus shown in this example includes, for example, the optical chip 400, a transfer substrate 1801, the EIC 301, and the EIC 302. A quantity of EICs included in the photoelectric conversion apparatus is not limited in this example. The photoelectric conversion apparatus shown in this example is packaged in a 2D manner, and the optical chip and each EIC are both flip-chip soldered to the transfer substrate 1801. For descriptions of the transfer substrate 1801, refer to the optional structure 2. Details are not described again. The optical chip and each EIC that are shown in this embodiment communicate an electrical signal through the transfer substrate 1801. It may be understood that the optical chip and the EIC that are shown in this example are packaged side by side on the transfer substrate 1801. The 2D manner is adopted for packaging, which improves efficiency of packaging the photoelectric conversion apparatus.

Optionally, the photoelectric conversion apparatus shown in this embodiment may not include the transfer substrate 1801, and solder balls led out from the optical chip are directly flip-chip soldered to the switch substrate 100 shown in FIG. 2. Details are not described herein again.

It should be noted that the description of a packaging form of the photoelectric conversion apparatus in this embodiment is an optional example, and is not limited. For example, in another example, the packaging form of the photoelectric conversion apparatus may also adopt a 2.5D packaging form or the like.

This application further provides a CPO chip. The CPO chip includes a switch substrate, a logic processing chip, and a photoelectric conversion apparatus. Both the photoelectric conversion apparatus and the logic processing chip are connected to the switch substrate, and the switch substrate is connected to a PCB. In this embodiment, an example in which the logic processing chip and the photoelectric conversion apparatus are both flip-chip soldered to the switch substrate is used. For details, refer to FIG. 2. Details are not described again.

This application further provides a photoelectric conversion apparatus. For descriptions of a structure of the photoelectric conversion apparatus, refer to any one of examples in FIG. 3, FIG. 16, FIG. 17, and FIG. 18. Details are not described again.

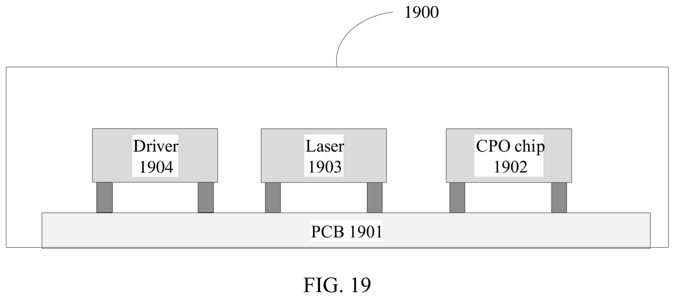

This application further provides an optical communication device. FIG. 19 is an example diagram of a structure of an embodiment of the optical communication device according to this application. The optical communication device includes an outer housing 1900, a circuit board 1901, a driver 1904, a laser 1903, and a CPO chip 1902. The outer housing 1900 shown in this embodiment is configured to fasten the circuit board 1901. In this embodiment, an example in which the circuit board 1901 is a PCB is used. A type of the circuit board is not specifically limited. The driver 1904, the laser 1903, and the CPO chip 1902 are all packaged on a surface of the PCB 1901. For example, at least one of the driver 1904, the laser 1903, and the CPO chip 1902 may be packaged on the surface of the PCB 1901 via a socket. For another example, at least one of the driver 1904, the laser 1903, and the CPO chip 1902 may be packaged on the surface of the PCB 1901 in a flip-chip soldering manner. This is not specifically limited in this embodiment.

If the CPO chip 1902 is configured to send a first service to another optical communication device, a logic processing chip of the CPO chip 1902 sends a first electrical signal that carries the first service to a photoelectric conversion apparatus, and the driver 1904 drives the laser 1903 to send a first optical signal to the CPO chip 1902. The photoelectric conversion apparatus of the CPO chip 1902 receives the first optical signal from the laser 1903. The photoelectric conversion apparatus is further configured to modulate the first electrical signal onto the first optical signal to obtain a modulated first optical signal. The CPO chip 1902 sends the modulated first optical signal to the another optical communication device through an optical fiber connector.

If the CPO chip 1902 is configured to receive a second service from the another optical communication device, the photoelectric conversion apparatus receives, from the another optical communication device through the optical fiber connector, a second optical signal that carries the second service. The photoelectric conversion apparatus performs optical-to-electrical conversion on the second optical signal to obtain a second electrical signal, and sends the second electrical signal to the logic processing chip of the CPO chip 1902. Components such as a trans-impedance amplifier and a power supply may be further packaged on the PCB 1901 shown in this embodiment. A type of the component packaged on the PCB 1901 is not specifically limited.

This application further provides an optical network. The optical network includes at least two optical communication devices that are connected through an optical fiber. For descriptions of the optical communication device, refer to FIG. 19. Details are not described again.

The foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. An optical chip, comprising an optical fiber connector, a photonic integrated circuit PIC, a protective housing, and an injection molding layer, wherein the protective housing is located between the injection molding layer and the PIC, and coupling space is formed between the protective housing and the PIC; and
the optical fiber connector comprises an optical fiber, the optical fiber connector has a first connection end that faces the PIC and a second connection end that is away from the PIC, a first coupling end of the optical fiber passes through the first connection end, the first coupling end and a second coupling end of an optical waveguide of the PIC both extend into the coupling space, the first coupling end located in the coupling space is coupled to the second coupling end, and the second connection end is configured to detachably connect to another optical fiber connector.

2. The optical chip according to claim 1, wherein a groove is concavely disposed on a surface that is of the PIC and that faces the protective housing, the groove is configured to fasten the first coupling end, and an axial center of the first coupling end located in the groove is aligned with an axial center of the second coupling end.

3. The optical chip according to claim 2, wherein the groove has a first side wall and a second side wall that are at opposite positions, and the first coupling end separately abuts against the first side wall and the second side wall.

4. The optical chip according to claim 3, wherein an included angle between the first side wall and the second side wall is an acute angle.

5. The optical chip according to any one of claims 2 to 4, wherein there is a groove opening at a position that is of the groove and that faces the protective housing, the protective housing covers the groove opening in a direction perpendicular to the surface of the PIC, and the first coupling end further abuts against the protective housing through the groove opening.

6. The optical chip according to any one of claims 1 to 5, wherein there is a gap between the PIC and the optical fiber connector, the optical fiber comprises a connection section connected between the first coupling end and the optical fiber connector, and the connection section passes through the gap, to enable the first coupling end to extend into the coupling space; and
a first orthographic projection and a second orthographic projection are obtained when a projection ray is separately incident to the connection section and the protective housing in a direction perpendicular to the surface of the PIC, and the first orthographic projection is located within coverage of the second orthographic projection.

7. The optical chip according to claim 6, wherein in the direction perpendicular to the surface of the PIC, there is a first distance between the first coupling end and the protective housing, there is a second distance between the connection section and the protective housing, and the second distance is not greater than the first distance.

8. A photoelectric conversion apparatus, comprising at least one electronic integrated circuit EIC and the optical chip according to any one of claims 1 to 7, wherein each of the at least one EIC is electrically connected to the optical chip.

9. The photoelectric conversion apparatus according to claim 8, wherein each EIC is flip-chip soldered to a transfer substrate, the optical chip is flip-chip soldered to a side surface that is of the EIC and that is away from the transfer substrate, and the EIC is electrically connected to the optical chip through the transfer substrate.

10. The photoelectric conversion apparatus according to claim 8, wherein the optical chip is flip-chip soldered to a transfer substrate, the EIC is flip-chip soldered to a side surface that is of the optical chip and that is away from the transfer substrate, and the EIC is electrically connected to the optical chip through the transfer substrate.

11. The photoelectric conversion apparatus according to claim 8, wherein the optical chip and each EIC are separately flip-chip soldered to a transfer substrate, and the EIC is electrically connected to the optical chip through the transfer substrate.

12. A co-packaged optics chip, comprising a switch substrate, a logic processing chip, and the photoelectric conversion apparatus according to any one of claims 8 to 11, wherein the logic processing chip and the photoelectric conversion apparatus are both flip-chip soldered to the switch substrate.

13. An optical communication device, comprising an outer housing, a circuit board, a driver, a laser, and the co-packaged optics chip according to claim 12, wherein the inside of the outer housing is configured to fasten the circuit board, and the driver, the laser, and the co-packaged optics chip are all packaged on a surface of the circuit board; and
the driver is configured to drive the laser to send a first optical signal to the co-packaged optics chip, wherein the co-packaged optics chip is configured to modulate the first optical signal to obtain a modulated first optical signal, and the co-packaged optics chip is configured to emit the modulated first optical signal; or
the co-packaged optics chip is configured to receive a second optical signal, and the co-packaged optics chip is further configured to convert the second optical signal into an electrical signal through optical-to-electrical conversion.
